# EUROPEAN PATENT APPLICATION

(11) **EP 4 435 851 A2**
(43) Date of publication of application: **25.09.2024**
(21) Application number: 24163968.1
(22) Date of filing: 15.03.2024
(51) Int. Cl.: H01L 23/427

(54) **SEMICONDUCTOR DEVICE**

(30) Priority: 23.03.2023 US 202363491784 P; 16.11.2023 US 202318510825
(71) Applicant: MediaTek Inc., 30078 Hsinchu City (TW)
(72) Inventor: HUANG, Pu-Shan, 30078 Hsinchu City (TW); CHEN, Chi-Yuan, 30078 Hsinchu City (TW); LIN, Shih-Chin, 30078 Hsinchu City (TW)
(74) Representative: Haseltine Lake Kempner LLP

(57) **Abstract**

A semiconductor device is provided. The semiconductor device includes a substrate, a semiconductor die, a lid, a liquid metal, a gel and a thermal dissipation structure. The semiconductor die is disposed on the substrate. The lid is disposed on the substrate and covers the semiconductor die. The lid has an opening to expose the semiconductor die. The liquid metal is disposed on the semiconductor die. The gel is disposed between the semiconductor die and the lid. The thermal dissipation structure is disposed on the lid and covers the opening. The semiconductor die, the gel and the thermal dissipation structure form a closed space for accommodating the liquid metal.

## Description

This application claims the benefit of U.S. Provisional Application No. 63/491,784, filed on March 23, 2023, the entirety of which is incorporated by reference herein.

### BACKGROUND OF THE DISCLOSURE

### Field of the Disclosure

The present disclosure relates to a semiconductor device and, in particular, to a semiconductor device including a liquid metal.

### Description of the Related Art

Conventional semiconductor device includes a substrate and an electronic component disposed on the substrate. However, the electronic component inevitably generates heat during operation. Thus, how to dissipate the heat from the electronic component has become a prominent task for the industry.

### BRIEF SUMMARY OF THE DISCLOSURE

An embodiment of the present disclosure provides a semiconductor device. The semiconductor device includes a substrate, a semiconductor die, a lid, a liquid metal, a gel and a thermal dissipation structure. The semiconductor die is disposed on the substrate. The lid is disposed on the substrate and covers the semiconductor die. The lid has an opening to expose the semiconductor die. The liquid metal is disposed on the semiconductor die. The gel is disposed between the semiconductor die and the lid. The thermal dissipation structure is disposed on the lid and covers the liquid metal. The semiconductor die, the gel and the thermal dissipation structure form a closed space for accommodating the liquid metal.

In some embodiments, the lid comprises an extending portion extending towards the semiconductor die, and the gel is in contact with the extending portion of the lid to seal a gap between the semiconductor die and the extending portion. In some embodiments, a bottom surface of the extending portion is higher than or flush with a top surface of the semiconductor die. In some embodiments, a top surface of the thermal dissipation structure is flush with a top surface of the lid. In some embodiments, the thermal dissipation structure has a protrusion portion protruding from a bottom surface and/or a top surface of the thermal dissipation structure. In some embodiments, a bottom surface of the extending portion is lower than a top surface of the semiconductor die; and/or a top surface of the extending portion is flush with the top surface of the semiconductor die. In some embodiments, the thermal dissipation structure comprises a metal plate or a heat sink. In some embodiments, the gel is affixed to the thermal dissipation structure. In some embodiments, the thermal dissipation structure covers a top surface of the extending portion, and the gel fills a gap between the thermal dissipation structure and the top surface of the extending portion. In some embodiments, the gel fills a recess of thermal dissipation structure, wherein the recess is recessed from a bottom surface of the thermal dissipation structure. In some embodiments, the gel is arranged on an edge of a top surface of the semiconductor die. In some embodiments, the semiconductor device further includes conductive structures disposed between the substrate and the semiconductor die. In some embodiments, the semiconductor device further includes an underfill arranged between the substrate and the semiconductor die and surrounding the conductive elements. In some embodiments, the lid is arranged on the substrate by an adhesive. In some embodiments, the thermal dissipation structure is arranged on the lid by an adhesive. In some embodiments, the semiconductor device further includes a molding compound surrounding the semiconductor die. The gel is arranged on an edge of a top surface of the molding compound. In some embodiments, the liquid metal is in contact with an entire top surface of the semiconductor die. In some embodiments, a bottom surface of the extending portion is higher than or flush with a top surface of the semiconductor die; or the bottom surface of the extending portion is lower than the top surface of the semiconductor die. In some embodiments, a top surface of the extending portion is flush with a top surface of the semiconductor die.

An embodiment of the present disclosure provides a semiconductor device. The semiconductor device includes a substrate, a semiconductor die, a molding compound, a lid, a gel and a liquid metal. The semiconductor die is disposed on the substrate. The lid is disposed on the substrate and covers the semiconductor die and the molding compound. The gel is arranged between the molding compound and the lid. The liquid metal is arranged between an entire top surface of the semiconductor die and the lid. The semiconductor die, the lid, the gel and the thermal dissipation structure form a closed space for accommodating the liquid metal.

In some embodiments, the lid has a recess on a bottom surface of the lid; or the lid has a protrusion portion protruding from the bottom surface of the lid. In some embodiments, the lid is an integrated structure.

### BRIEF DESCRIPTION OF THE DRAWINGS

The present disclosure can be more fully understood by reading the subsequent detailed description and examples with references made to the accompanying drawings, wherein:

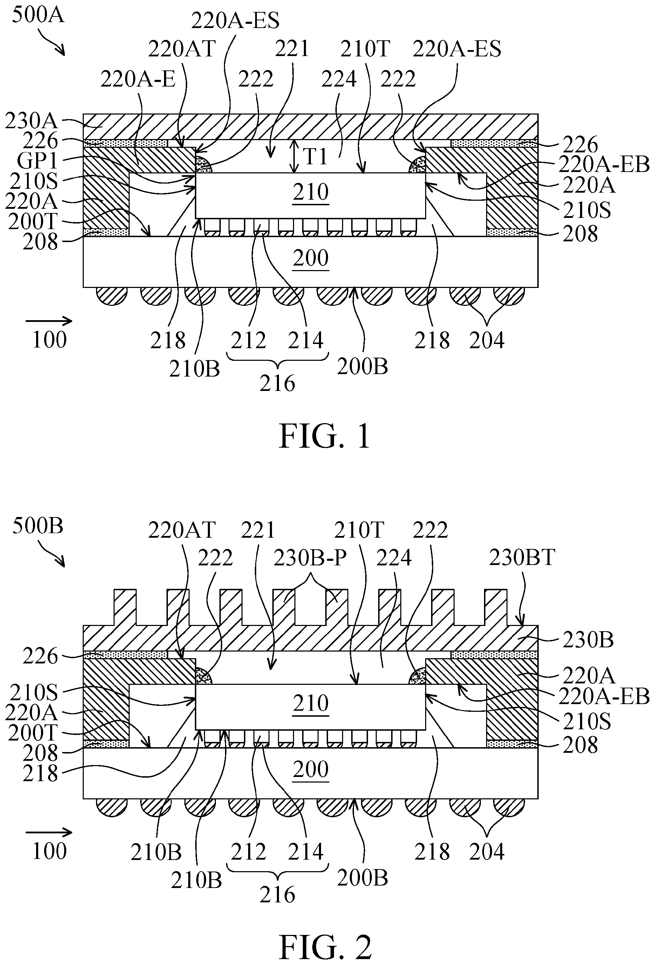

FIGS. 1, 2, 3, 4, 5, 6, 7, 8, 9, 10, 11, 12, 13, 14, 15 and 16 are cross-sectional views of a semiconductor device in accordance with some embodiments of the disclosure.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

The inventive concept is described fully hereinafter with reference to the accompanying drawings, in which exemplary embodiments of the inventive concept are shown. The advantages and features of the inventive concept and methods of achieving them will be apparent from the following exemplary embodiments that will be described in more detail with reference to the accompanying drawings. It should be noted, however, that the inventive concept is not limited to the following exemplary embodiments, and may be implemented in various forms. Accordingly, the exemplary embodiments are provided only to disclose the inventive concept and let those skilled in the art know the category of the inventive concept. Also, the drawings as illustrated are only schematic and are nonlimiting. In the drawings, the size of some of the elements may be exaggerated for illustrative purposes and not drawn to scale. The dimensions and the relative dimensions do not correspond to actual dimensions in the practice of the disclosure.

With the increased usage of the semiconductor devices, satisfying power needs has become a priority. When the device power is getting higher, the thermal dissipation of the semiconductor device is highly concerned to avoid performance degradation of the semiconductor device induced by the high temperature. The conventional thermal interface material 1 (TIM 1) dispensed between a flip-chip semiconductor die and a heat-spreading lid has poor heat dissipation capability for the semiconductor device in high-power operation. Therefore, liquid metals (LMs) with high thermal conductivity may act as an excellent solution to high thermal problem. However, the liquid metal used in TIM1 applications may easily spread to undesired spaces and further cause coverage issue and circuit short problem while touching the substrate or electronic components (such as semiconductor dies/capacitors/resistors/inductors). When the temperature rises or the semiconductor device isn't fixed horizontally, the liquid metal will flow outside, and further pollute the substrate or other components (such as semiconductor dies/capacitors/resistors/inductors). Thus, a novel semiconductor device that includes a liquid metal is desirable.

FIG. 1 is a cross-sectional view of a semiconductor device 500A in accordance with some embodiments of the disclosure. In some embodiments, the semiconductor device 500A is a portion of mobile phones, personal digital assistants (PDA), digital cameras, and servers, etc.. The semiconductor device 500A is capable of applying to (or disposed on) a package requiring high-power operation, such as flip chip ball grid array (FCBGA), land grid array (LGA), fan-out package, three-dimensional (3D) integrated circuit (IC) package, etc.. As show in FIG. 1, the semiconductor device 500A includes a substrate 200, a semiconductor die 210, a lid 220A, a liquid metal 224, a gel 222 and a thermal dissipation structure 230A.

The substrate 200 can be a single layer or a multilayer structure. In some embodiments, the substrate 200 is, for example, a printed circuit board (PCB), an interposer, a package substrate, another semiconductor device or a semiconductor package. In some embodiments, the substrate 200 may be formed of dielectric materials (e.g., polypropylene (PP), epoxy, polyimide, or other applicable resin materials) or semiconductor materials. The substrate 200 has a top surface 200T and a bottom surface 200B opposite the top surface 200T. The substrate 200 is provided for the semiconductor die 210 disposed on the top surface 200T. A plurality of conductive traces (not shown), conductive vias and/or conductive pads (not shown) are disposed in the substrate 200. The conductive traces may be electrically connected to the corresponding conductive vias and conductive pads. The conductive pads and/or the conductive traces are exposed to openings of solder mask layers (not shown) disposed close to the top surface 200T and the bottom surface 200B. In one embodiment, the conductive traces may comprise signal trace segments or ground trace segments, which are used for the input/output (I/O) connections of the semiconductor die 210. Also, the conductive pads are disposed on the top surface 200T of the substrate 200, connected to different terminals of the conductive traces. The conductive pads are used for the semiconductor die 210 that is mounted directly on them.

The semiconductor device 500A further includes conductive structures 204 disposed on the bottom surface 200B of substrate 200 away from the semiconductor die 210 and in contact with the corresponding the conductive pads (not shown) of the substrate 200. In some embodiments, the conductive structures 204 includes a conductive ball structure such as a solder ball, copper-core solder ball, a conductive bump structure such as a copper bump or a solder bump structure, or a conductive pillar structure such as a copper pillar structure.

As shown in FIG. 1, the semiconductor die 210 is flipped to be disposed on the substrate 200 opposite the conductive structures 204 by a bonding process. The semiconductor die 210 is mounted on the substrate 200 using conductive structures 216. In addition, the semiconductor die 210 is electrically connected to the conductive structures 204 by the substrate 200. The semiconductor die 210 is, for example, a fan-out semiconductor die, such a central processing unit (CPU), a graphic processing unit (GPU), a dynamic random access memory (DRAM) controller or any combination thereof. In some embodiments, the semiconductor die 210 is fabricated by a flip-chip technology.

In some embodiments, the conductive structures 216 are electrically connected to the conductive pads (including conductive traces) of the substrate 200. In some embodiments, the conductive structures 216 include a conductive ball structure such as a solder ball, copper-core solder ball, a conductive bump structure such as a copper bump or a solder bump structure, or a conductive pillar structure such as a copper pillar structure. For example, one of the conductive structures 216 may include a conductive pillar structure 212 and a conductive bump structure 214.

As shown in FIG. 1, the semiconductor device 500A further includes an underfill 218 arranged between the substrate 200 and the semiconductor die 210. The underfill 218 surrounds the conductive elements 216. The underfill 218 fills the gap (not shown) between the substrate 200 and the semiconductor die 210. The underfill 218 covers a bottom surface 210B of the semiconductor die 210 and the top surface 200T of substrate 200. The underfill 218 is also in contact with the bottom surface 210B of the semiconductor die 210 and the top surface 200T of substrate 200. The underfill 218 may help to dissipate heat generated from the semiconductor die 210 and to reduce the thermal resistance from the semiconductor die 210 to the substrate 200. The underfill 218 surrounds and covers side surfaces 2105 of the semiconductor die 210. The underfill 218 may be in contact with the side surfaces 2105 of the semiconductor die 210. The underfill 218 may help stabilize the semiconductor die 210.

As shown in FIG. 1, the lid 220A is disposed on the substrate 200. In addition, the lid 220A is disposed so that it surrounds and covers side surfaces 2105 of the semiconductor die 210. The lid 220A may also surround and cover the underfill 218. The lid 220A and the underfill 218 may not be in contact with each other. In some embodiments, there is a space between the lid 220A and the underfill 218. In some embodiments, the lid 220A includes an extending portion 220A-E extending towards the semiconductor die 210. The extending portion 220A-E may also cover the space between the lid 220A and the underfill 218. The extending portion 220A-E has an opening 221 (or a through hole) directly above the semiconductor die 210 to expose an entire top surface 210T of the semiconductor die 210. The extending portion 220A-E has a top surface 220AT and a bottom surface 220A-EB. The top surface 220AT may also serve as the top surface of the lid 220A. In some embodiments, the bottom surface 220A-EB of the extending portion 220A-E is higher than or flush with the top surface 210T of the semiconductor die 210. In some embodiments, the lid 220A may be made by a metal material, such as copper, aluminum, iron or a combination thereof. In some embodiments, the lid 220A may be made by a non-metal material, such as a ceramic material, a polymer material or another applicable non-metal material. The lid 220A could conduct heat and increase strength of the semiconductor device 500A for reducing warpage.

As shown in FIG. 1, the semiconductor device 500A further includes an adhesive 208 disposed between the lid 220A and the on the top surface 200T of the substrate 200, so that the lid 220A is arranged on the top surface 200T of the substrate 200.

As shown in FIG. 1, the gel 222 is disposed between the semiconductor die 210 and the lid 220A. The gel 222 may be arranged on an edge of the top surface 210T of the semiconductor die 210. In addition, the gel 222 may be in contact with a side surface 220A-ES of the extending portion 220A-E of the lid 220A to seal a gap GP1 between the semiconductor die 210 and the extending portion 220A-E. In some embodiments, the gel 222 covers and is contact with a portion of the top surface 210T of the semiconductor die 210. In some embodiments, the gel 222 includes a silicone based material, an epoxy based material, an acrylic based material, a silver paste, etc..

As shown in FIG. 1, the liquid metal 224 is disposed on the semiconductor die 210 and in contact with the top surface 210T of the semiconductor die 210. In some embodiments, the semiconductor die 210, the gel 222, the extending portion 220A-E of the lid 220A and the thermal dissipation structure 230A may collectively form a closed space to accommodate the liquid metal 224. In some embodiments, the liquid metal 224 may substantially fill up the closed space. In terms of the property, the liquid metal 224 may have melting point ranging between 25° C. to 70° C., lower or higher. The thermal conductivity of the liquid metal 224 is higher than that of the conventional thermal interface material (TIM). Generally, the TIM has thermal conductivity ranging between 2 W/m-K to 10 W/m-K. In some embodiments, the liquid metal 224 includes a gallium alloys or a compound of gallium, indium (e.g., eutectic gallium indium (EGaIn) (75% gallium and 25% indium) and Galinstan (GaInSn) (68.5% gallium, 21.5% indium and 10% tin)).

As shown in FIG. 1, the thermal dissipation structure 230A is disposed on the lid 220A. The thermal dissipation structure 230A may be arranged on the top surface 220AT of the lid 220A by an adhesive 226. In addition, the thermal dissipation structure 230A may laterally (along a direction 100) extend over the top surface 220AT of the lid 220A to cover the opening 221. The plate-shaped thermal dissipation structure 230A may have a uniform thickness. In some embodiments, the thermal dissipation structure 230A and the lid 220A may comprise the same or similar materials. In some embodiments, the thermal dissipation structure 230A comprises a metal plate, ceramic plate, or a heat sink. In some embodiments, a bottom surface of the thermal dissipation structure 230A is a flat surface. In some embodiments, the gel 222 and the adhesives 208 and 226 may comprise same or similar materials. In some embodiments, the thermal dissipation structure 230A and the lid 220A are separate structures, not an integrated structure.

In some embodiments, the lid 220A having the opening 221 is used in combination with the thermal dissipation structure 230A, and the gel 222 is used to seal the gap between the semiconductor die 210 and the lid 220A. The lid 220A and the thermal dissipation structure 230A may collectively form a composite lid. In addition, as the gap between the semiconductor die 210 and the extending portion 220A-E of the lid 220A is sealed by the gel 222 and the adhesive 226 is disposed between the lid 220A and the thermal dissipation structure 230A, as a result, the semiconductor die 210, the extending portion 220A-E of the lid 220A and the thermal dissipation structure 230A may collectively form the closed space to accommodate the liquid metal 224 filling within, thereby providing a heat dissipating path with low-thermal resistance. In some embodiments, the semiconductor die 210, the gel 222, the extending portion 220A-E of the lid 220A, the adhesive 226 and the thermal dissipation structure 230A may collectively form the closed space. In some embodiments, the top surface 210T of the semiconductor die 210, the gel 222, the extending portion 220A-E of the lid 220A, the adhesive 226 and the bottom surface of the thermal dissipation structure 230A may collectively form the closed space. In addition, as the liquid metal 224 is stably sealed in the closed space, when the semiconductor device 500A is shipped, the area of the top surface 210T of the semiconductor die 210 covered by the liquid metal 224 may keep the same. Being stably sealed in the closed space can also prevent the liquid metal 224 from leaking to outside. Therefore, the circuit short problem is eliminated, and the heat dissipation capability of the semiconductor device can be further improved.

In some embodiments, the gel 222 may completely cover the side surface 220A-ES of the extending portion 220A-E of the lid 220A, and the adhesive 226 may completely cover the top surface 220AT of the lid 220A. In such an embodiment, the closed space may be formed by the semiconductor die 210, the gel 222, the adhesive 226 and the thermal dissipation structure 230A. In more detail, the closed space may be formed by the top surface 210T of the semiconductor die 210, the gel 222, the adhesive 226 and the bottom surface of the thermal dissipation structure 230A. In some embodiments, the gel 222 may be in contact with the adhesive 226. In some embodiments, the gel 222 may be in contact with the bottom surface of the thermal dissipation structure 230A. As a result, the liquid metal 224 may not be in contact with the lid 220A and the adhesive 226. In such an embodiment, the closed space may be formed by the semiconductor die 210, the gel 222 and the thermal dissipation structure 230A. In more detail, the closed space may be formed by the top surface 210T of the semiconductor die 210, the gel 222 and the bottom surface of the thermal dissipation structure 230A. According to some embodiments, the lid 220A may be used to provide mechanical support for forming the closed space. Therefore, the liquid metal 224 can be stably sealed in the closed space to avoid spillage of the liquid metal.

FIG. 2 is a cross-sectional view of a semiconductor device 500B in accordance with some embodiments of the disclosure. Elements of the embodiments hereinafter, that are the same or similar as those previously described with reference to FIG. 1 are not repeated for brevity. The difference between the semiconductor device 500A and the semiconductor device 500B at least includes a thermal dissipation structure 230B with at least one protrusion portion 230B-P. The protrusion portion 230B-P extends upwards form from a top surface 230BT of the thermal dissipation structure 230B . In some embodiments, the fin-shaped protrusion portion 230B-P may increase the surface area of the thermal dissipation structure 230B. Therefore, the heat dissipation capability of the semiconductor device 500B can be further improved.

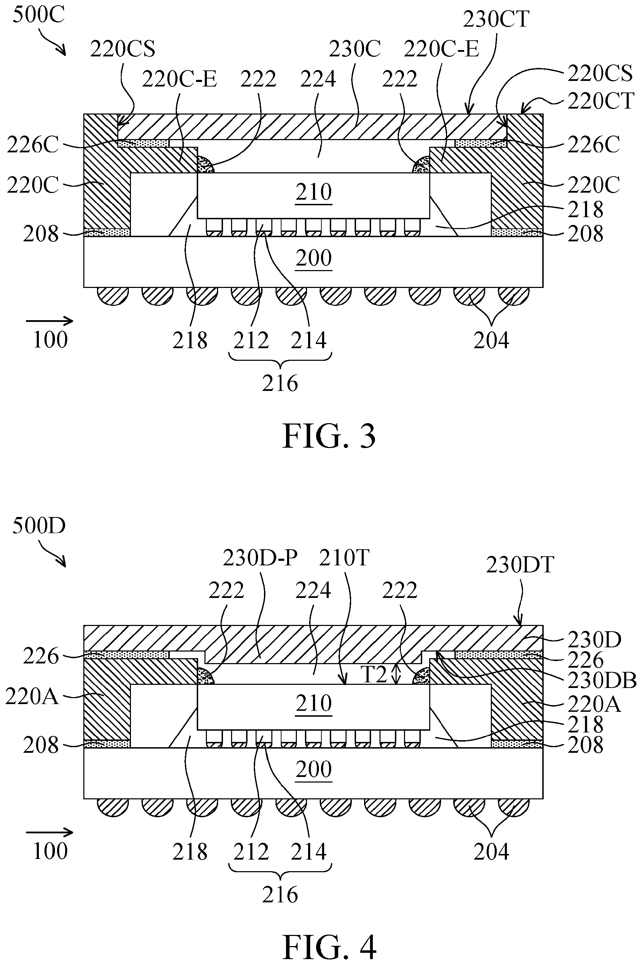

FIG. 3 is a cross-sectional view of a semiconductor device 500C in accordance with some embodiments of the disclosure. Elements of the embodiments hereinafter, that are the same or similar as those previously described with reference to FIGS. 1 and 2 are not repeated for brevity. The difference between the semiconductor device 500A and the semiconductor device 500C at least includes a thermal dissipation structure 230C disposed on a lid 220C. The thermal dissipation structure 230C is mounted on an extending portion 220C-E of the lid 220C by an adhesive 226C. In addition, the thermal dissipation structure 230C and the adhesive 226C are surrounded by the lid 220C. Side surfaces (not shown) of the thermal dissipation structure 230C is connected to side surfaces 220CS of the lid 220C which is above the extending portion 220C-E. In some embodiments, a top surface 230CT of the thermal dissipation structure 230C is flush with a top surface 220CT of the lid 220C. The top surface 230CT of the thermal dissipation structure 230C may be a flat surface and the thermal dissipation structure 230C has no opening on the top surface 230CT. It is convenient for manufacturing and subsequent installation of the semiconductor device 500C.

FIG. 4 is a cross-sectional view of a semiconductor device 500D in accordance with some embodiments of the disclosure. Elements of the embodiments hereinafter, that are the same or similar as those previously described with reference to FIGS. 1 to 3 are not repeated for brevity. The difference between the semiconductor device 500A and the semiconductor device 500D at least includes a thermal dissipation structure 230D with at least one protrusion portion 230D-P. The at least one protrusion portion 230D-P is facing the opening. The protrusion portion 230D-P protrudes from a bottom surface 230DB of the thermal dissipation structure 230D and extends towards the top surface 210T of the semiconductor die 210. In other words, the bottom surface of the thermal dissipation structure 230D is not a flat surface. A top surface 230DT of the thermal dissipation structure 230D may be a flat surface and the thermal dissipation structure 230D has no opening on the top surface 230DT. In some embodiments, the protrusion portion 230D-P may reduce a thickness T2 of the liquid metal 224 (e.g., the thickness T2 of the liquid metal 224 of the semiconductor device 500D is thinner than a thickness T1 of the liquid metal 224 of the semiconductor device 500A shown in FIG. 1) in order to improve heat dissipation efficiency and speed up heat dissipation. Therefore, the heat dissipation capability of the semiconductor device 500B can be further improved.

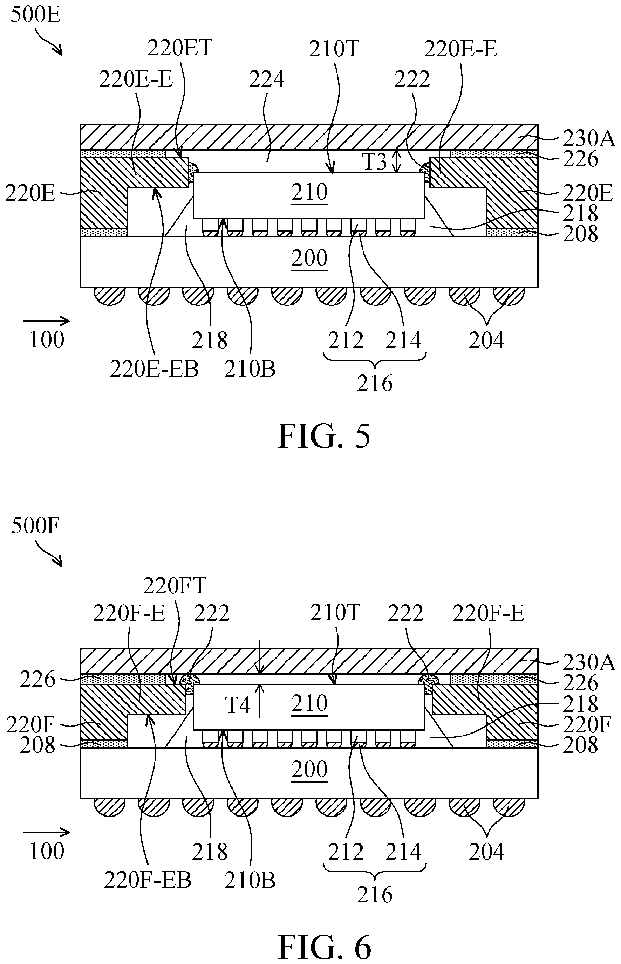

FIG. 5 is a cross-sectional view of a semiconductor device 500E in accordance with some embodiments of the disclosure. Elements of the embodiments hereinafter, that are the same or similar as those previously described with reference to FIGS. 1 to 4 are not repeated for brevity. The difference between the semiconductor device 500A and the semiconductor device 500E at least includes a lid 220E with an extending portion 220E-E. In some embodiments, a bottom surface 220E-EB of the extending portion 220E-E is lower than the top surface 210T of the semiconductor die 210. In addition, the top surface 210T of the semiconductor die 210 may be lower than a top surface 220ET of the extending portion 220E-E. Therefore, the total height of the semiconductor device 500E can be reduced. In some embodiments, the lower extending portion 220E-E may reduce a thickness T3 of the liquid metal 224 (e.g., the thickness T3 of the liquid metal 224 of the semiconductor device 500E is thinner than a thickness T1 of the liquid metal 224 of the semiconductor device 500A shown in FIG. 1) in order to improve heat dissipation efficiency and speed up heat dissipation. Therefore, the heat dissipation capability of the semiconductor device 500E can be further improved. In some embodiments, the semiconductor device 500E shown in FIG. 5 may use the thermal dissipation structure 230D having the protrusion portion 230D-P (FIG. 4) instead of the thermal dissipation structure 230A. In some embodiments, the closed space of the semiconductor device 500E may be formed by the semiconductor die 210, the extending portion 220E-E of the lid 220E, the gel 222, the adhesive 226 and the thermal dissipation structure 230A. In some embodiments, when the gel 222 completely cover the side surface of the extending portion 220E-E of the lid 220E and the adhesive 226 completely cover the top surface 220ET of the lid 220E, the closed space of the semiconductor device 500E may be formed by the semiconductor die 210, the gel 222, the adhesive 226 and the thermal dissipation structure 230A. In some embodiments, the gel 222 may be in contact with the bottom surface of the thermal dissipation structure 230A, and the closed space of the semiconductor device 500E may be formed by the semiconductor die 210, the gel 222 and the thermal dissipation structure 230A. According to some embodiments, the lid 220E may be used to provide mechanical support for forming the closed space. Therefore, the liquid metal 224 can be stably sealed in the closed space to avoid spillage of the liquid metal.

FIG. 6 is a cross-sectional view of a semiconductor device 500F in accordance with some embodiments of the disclosure. Elements of the embodiments hereinafter, that are the same or similar as those previously described with reference to FIGS. 1 to 5 are not repeated for brevity. The difference between the semiconductor device 500E and the semiconductor device 500F at least includes a lid 220F with an extending portion 220F-E. In some embodiments, a top surface 220FT of the extending portion 220F-E (it also serves as the top surface of the lid 220F) is flush with the top 210T of the semiconductor die 210. In addition, a bottom surface 220F-EB of the extending portion 220F-E may be lower than the top surface 210T of the semiconductor die 210. Furthermore, the gel 222 may be affixed to, and in contact with, the semiconductor die 210, the lid 220F and the thermal dissipation structure 230A. Therefore, the total height of the semiconductor device 500F can be reduced. Compared with the semiconductor device 500E, the semiconductor device 500F including the lower extending portion 220F-E may reduce a thickness T4 of the liquid metal 224 (e.g., the thickness T4 of the liquid metal 224 of the semiconductor device 500E is thinner than a thickness T3 of the liquid metal 224 of the semiconductor device 500E shown in FIG. 5) in order to further improve heat dissipation efficiency and speed up heat dissipation. Therefore, the heat dissipation capability of the semiconductor device 500F can be further improved. In some embodiments, the gel 222 seals the gap between the semiconductor die 210 and the extending portion 220F-E, and the gel 222 may be in contact with the bottom surface of the thermal dissipation structure 230A. As a result, the closed space of the semiconductor device 500F may be formed by the semiconductor die 210, the gel 222 and the thermal dissipation structure 230A. In some embodiments, the closed space may be formed by the top surface 210T of the semiconductor die 210, the gel 222 and the bottom surface of the thermal dissipation structure 230A. According to some embodiments, the lid 220F may be used to provide mechanical support for forming the closed space. Therefore, the liquid metal 224 can be stably sealed in the closed space to avoid spillage of the liquid metal.

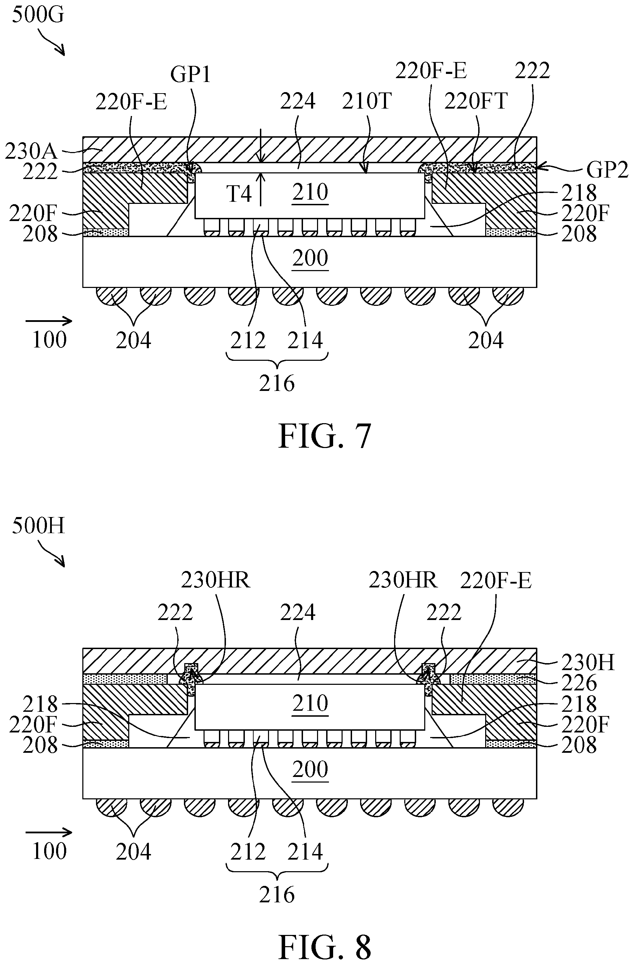

FIG. 7 is a cross-sectional view of a semiconductor device 500G in accordance with some embodiments of the disclosure. Elements of the embodiments hereinafter, that are the same or similar as those previously described with reference to FIGS. 1 to 6 are not repeated for brevity. The difference between the semiconductor device 500F and the semiconductor device 500G at least includes that the semiconductor device 500G uses the gel 222 sealing the gap GP1 between the semiconductor die 210 and the extending portion 220F-E. In addition, the gel 222 fills a gap GP2 between the thermal dissipation structure 230A and a top surface 220FT of the extending portion 220F-E (it also serves as the top surface of the lid 220F). Compared with the semiconductor device 500F, the lid 220F of the semiconductor device 500G may be attached to the thermal dissipation structure 230A only by the gel 222 (without using the adhesive 226 shown in FIG. 6). In some embodiments, the closed space of the semiconductor device 500G may be formed by the semiconductor die 210, the gel 222 and the thermal dissipation structure 230A. In some embodiments, the closed space of the semiconductor device 500G may be formed by the top surface 210T of the semiconductor die 210, the gel 222 and the bottom surface of the thermal dissipation structure 230A. According to some embodiments, the lid 220F may be used to provide mechanical support for forming the closed space. Therefore, the liquid metal 224 can be stably sealed in the closed space to avoid spillage of the liquid metal.

FIG. 8 is a cross-sectional view of a semiconductor device 500H in accordance with some embodiments of the disclosure. Elements of the embodiments hereinafter, that are the same or similar as those previously described with reference to FIGS. 1 to 7 are not repeated for brevity. The difference between the semiconductor device 500H and the semiconductor device 500G at least includes a thermal dissipation structure 230H with a recess 230HR recessed from a bottom surface 230HB of the thermal dissipation structure 230H. The recess 230HR is positioned close to the edge of the semiconductor die 210. The gel 222 may fill the recess 230HR of thermal dissipation structure 230H. In some embodiments, the recess 230HR of thermal dissipation structure 230H may provide an addition space for the gel 222 filling within, the seal quality of the semiconductor device 500H may be improved. In some embodiments, the closed space of the semiconductor device 500H may be formed by the semiconductor die 210, the gel 222 and the thermal dissipation structure 230H. In some embodiments, the closed space of the semiconductor device 500H may be formed by the top surface 210T of the semiconductor die 210, the gel 222 and the bottom surface of the thermal dissipation structure 230H. According to some embodiments, the lid 220F may be used to provide mechanical support for forming the closed space. Therefore, the liquid metal 224 can be stably sealed in the closed space to avoid spillage of the liquid metal.

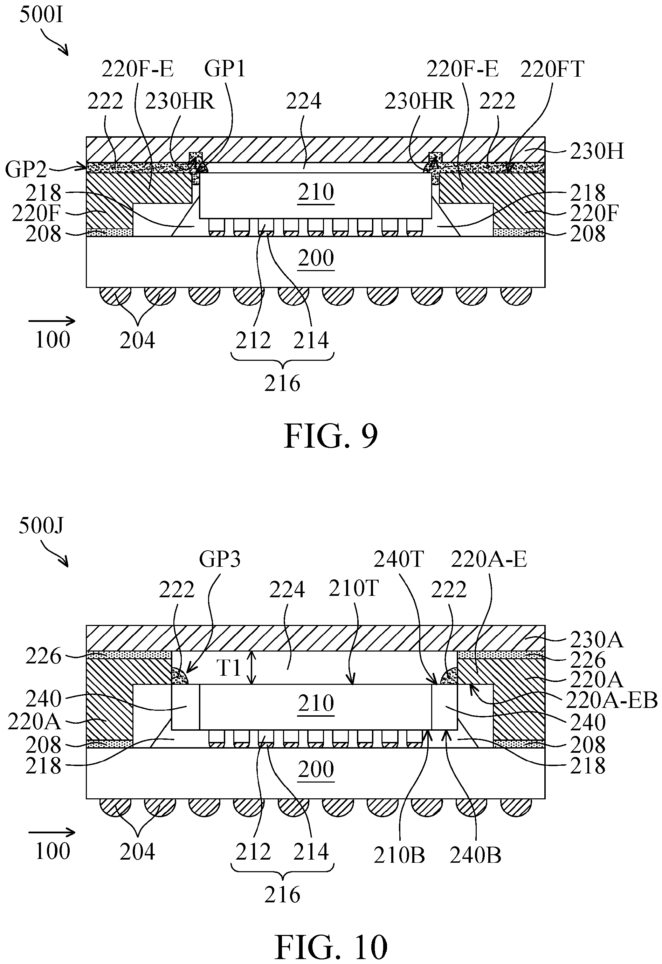

FIG. 9 is a cross-sectional view of a semiconductor device 500I in accordance with some embodiments of the disclosure. Elements of the embodiments hereinafter, that are the same or similar as those previously described with reference to FIGS. 1 to 8 are not repeated for brevity. The difference between the semiconductor device 500I and the semiconductor device 500H at least includes that the semiconductor device 500I uses the gel 222 sealing the gap GP1 between the semiconductor die 210 and the extending portion 220F-E. In addition, the gel 222 fills recess 230HR of thermal dissipation structure 230H and the gap GP2 between the thermal dissipation structure 230A and a top surface 220FT of the extending portion 220F-E (it also serves as the top surface of the lid 220F). Compared with the semiconductor device 500H, the lid 220F of the semiconductor device 500I may be attached to the thermal dissipation structure 230H only by the gel 222 (without using the adhesive 226 shown in FIG. 8). In some embodiments, the closed space of the semiconductor device 5001 may be formed by the semiconductor die 210, the gel 222 and the thermal dissipation structure 230H. In some embodiments, the closed space of the semiconductor device 500G may be formed by the top surface 210T of the semiconductor die 210, the gel 222 and the bottom surface of the thermal dissipation structure 230H. According to some embodiments, the lid 220F may be used to provide mechanical support for forming the closed space. Therefore, the liquid metal 224 can be stably sealed in the closed space to avoid spillage of the liquid metal.

In some embodiments, the semiconductor device may include a molding compound surrounding side surfaces of the semiconductor die 210. The molding compound may help to dissipate heat generated form the semiconductor die 210. In addition, the molding compound may provide an additional area for the dispensation of the gel 222. The thermal path area between the semiconductor die 210 and the liquid metal 224 may be increased, thereby improve heat dissipation efficiency from the semiconductor die 210 to the environment outside the semiconductor device.

FIG. 10 is a cross-sectional view of a semiconductor device 500J in accordance with some embodiments of the disclosure. Elements of the embodiments hereinafter, that are the same or similar as those previously described with reference to FIGS. 1 to 9 are not repeated for brevity. The difference between the semiconductor device 500A and the semiconductor device 500J at least includes a molding compound 240 surrounding the semiconductor die 210. The bottom surface 220A-EB of the extending portion 220A-E may be higher than or flush with the top surface 210T of the semiconductor die 210 and a top surface 240T of the molding compound 240. The top surface 210T of the semiconductor die 210 may be flush with the top surface 240T of the molding compound 240. The bottom surface 240B of the molding compound 240 may be flush with bottom surface 240B of the semiconductor die 210. In addition, the gel 222 may be arranged on the edge of the top surface 240T of the molding compound 240 without extending to cover the top surface 210T of the semiconductor die 210. In other words, the entire top surface 210T of the semiconductor die 210 is exposed form the gel 222. In addition, the gel 222 may seals a gap GP3 between the molding compound 240 and the extending portion 220A-E. Therefore, the liquid metal 224 is in contact with the entire top surface 210T of the semiconductor die 210. In some embodiments, the molded compound 240 may be formed of a nonconductive material, such as an epoxy, a resin, a moldable polymer, or the like. The molding compound 240 may be applied while substantially liquid, and then may be cured through a chemical reaction, such as in an epoxy or resin. In some other embodiments, the molding compound 240 may be an ultraviolet (UV) or thermally cured polymer applied as a gel or malleable solid capable of being disposed around the semiconductor die 210, and then may be cured using a UV or thermally curing process. The molding compound 240 may be cured with a mold. Compared the semiconductor device 500A, the gel 222 may be arranged on the molding compound 240 instead of the semiconductor die 210, so the thermal path between the semiconductor die 210 and the liquid metal 224 of the semiconductor device 500J is greater than that of the semiconductor device 500A. Therefore, the heat dissipation efficiency of the semiconductor device 500J is improved. In some embodiments, the semiconductor device 500J shown in FIG. 10 may use the thermal dissipation structure 230D having the protrusion portion 230D-P (FIG. 4) instead of the thermal dissipation structure 230A. In some embodiments, the closed space of the semiconductor device 500J may be formed by the semiconductor die 210, the molded compound 240, the gel 222, the extending portion 220A-E of the lid 220A, the adhesive 226 and the thermal dissipation structure 230A, as shown in FIG. 10. In some embodiments, the gel 222 may completely cover the top surface 240T of the molded compound 240, and the closed space of the semiconductor device 500J may be formed by the semiconductor die 210, the gel 222, the extending portion 220A-E of the lid 220A, the adhesive 226 and the thermal dissipation structure 230A. In some embodiments, the gel 222 may completely cover the side surface 220A-ES of the extending portion 220A-E of the lid 220A and the gel 222 may completely cover the top surface 240T of the molded compound 240, then the closed space of the semiconductor device 500J may be formed by the semiconductor die 210, the gel 222, the adhesive 226 and the thermal dissipation structure 230A. In some embodiments, the gel 222 may be in contact with the bottom surface of the thermal dissipation structure 230A. As a result, the liquid metal 224 may not be in contact with the lid 220A and the adhesive 226, and the closed space may be formed by the semiconductor die 210, the gel 222 and the thermal dissipation structure 230A. According to some embodiments, the lid 220A may be used to provide mechanical support for forming the closed space. Therefore, the liquid metal 224 can be stably sealed in the closed space to avoid spillage of the liquid metal.

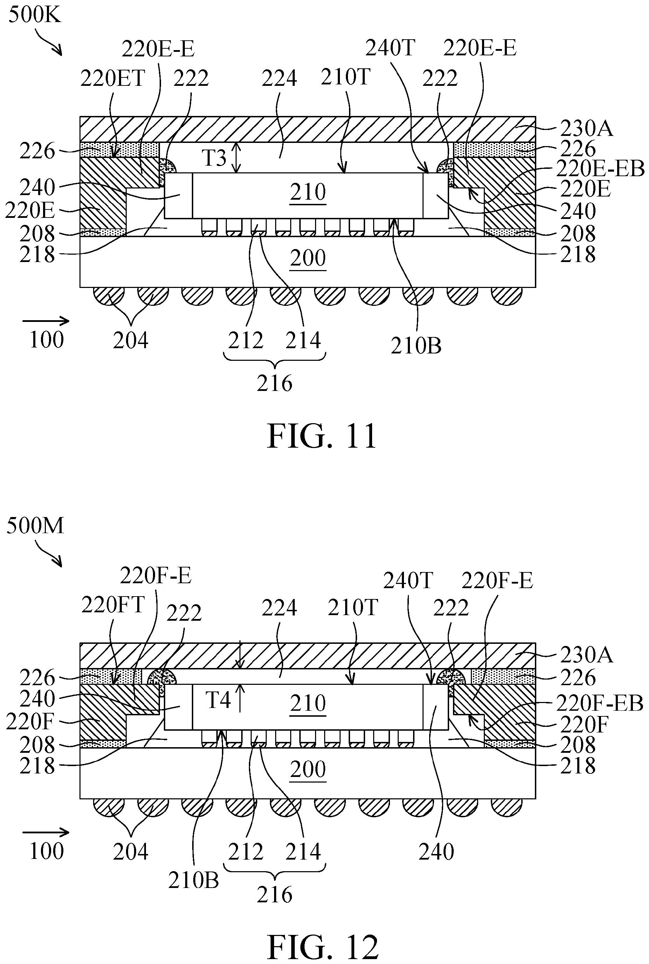

FIG. 11 is a cross-sectional view of a semiconductor device 500K in accordance with some embodiments of the disclosure. Elements of the embodiments hereinafter, that are the same or similar as those previously described with reference to FIGS. 1 to 10 are not repeated for brevity. The difference between the semiconductor device 500J and the semiconductor device 500K at least includes the lid 220E with the extending portion 220E-E. In some embodiments, the bottom surface 220E-EB of the extending portion 220E-E is lower than the top surface 210T of the semiconductor die 210 and the top surface 240T of the molding compound 240. In addition, the top surface 210T of the semiconductor die 210 (and the top surface 240T of the molding compound 240) may be positioned between the top surface 220ET and the bottom surface 220E-EB of the extending portion 220E-E. Therefore, the total height of the semiconductor device 500K can be reduced. In some embodiments, the lower extending portion 220E-E may reduce a thickness T3 of the liquid metal 224 (e.g., the thickness T3 of the liquid metal 224 of the semiconductor device 500K is thinner than the thickness T1 of the liquid metal 224 of the semiconductor device 500J shown in FIG. 10) in order to improve heat dissipation efficiency and speed up heat dissipation. Therefore, the heat dissipation capability of the semiconductor device 500K can be further improved. In some embodiments, the semiconductor device 500K shown in FIG. 11 may use the thermal dissipation structure 230D having the protrusion portion 230D-P (FIG. 4) instead of the thermal dissipation structure 230A. In some embodiments, the closed space of the semiconductor device 500K may be formed by the semiconductor die 210, the molded compound 240, the gel 222, the extending portion 220E-E of the lid 220E, the adhesive 226 and the thermal dissipation structure 230A, as shown in FIG. 11. In some embodiments, the gel 222 may completely cover the side surface of the extending portion 220E-E of the lid 220E, and the closed space of the semiconductor device 500K may be formed by the semiconductor die 210, the molded compound 240, the gel 222, the adhesive 226 and the thermal dissipation structure 230A. In some embodiments, the gel 222 may be in contact with the bottom surface of the thermal dissipation structure 230A, then the closed space of the semiconductor device 500K may be formed by the semiconductor die 210, the molded compound 240, the gel 222 and the thermal dissipation structure 230A. In addition, the gel 222 may further completely cover the top surface 240T of the molded compound 240, as a result, the closed space may be formed by the semiconductor die 210, the gel 222 and the thermal dissipation structure 230A. According to some embodiments, the lid 220E may be used to provide mechanical support for forming the closed space. Therefore, the liquid metal 224 can be stably sealed in the closed space to avoid spillage of the liquid metal.

FIG. 12 is a cross-sectional view of a semiconductor device 500M in accordance with some embodiments of the disclosure. Elements of the embodiments hereinafter, that are the same or similar as those previously described with reference to FIGS. 1 to 11 are not repeated for brevity. The difference between the semiconductor device 500K and the semiconductor device 500M at least includes that the extending portion 220F-E of the lid 220F of the semiconductor device 500M has a reduced height. In some embodiments, the top surface 220FT of the extending portion 220F-E (it also serves as the top surface of the lid 220F) is flush with the top surface 210T of the semiconductor die 210 (and the top surface 240T of the molding compound 240). In addition, the bottom surface 220F-EB of the extending portion 220F-E may be positioned between the top surface 210T and the bottom surface 210B of the semiconductor die 210 (and the top surface 240T and the bottom surface 240B of the molding compound 240). Therefore, the total height of the semiconductor device 500M can be reduced. Furthermore, the gel 222 may be affixed to, and in contact with, the molding compound 240, the lid 220F and the thermal dissipation structure 230A without extending to cover the top surface 210T of the semiconductor die 210. Compared with the semiconductor device 500K, the semiconductor device 500M including the lower extending portion 220F-E may reduce the thickness T4 of the liquid metal 224 (e.g., the thickness T4 of the liquid metal 224 of the semiconductor device 500M is thinner than the thickness T3 of the liquid metal 224 of the semiconductor device 500K shown in FIG. 11) in order to further improve heat dissipation efficiency and speed up heat dissipation. Therefore, the heat dissipation capability of the semiconductor device 500M can be further improved. In some embodiments, as shown in FIG. 12, the gel 222 may be in contact with the bottom surface of the thermal dissipation structure 230A, and the closed space of the semiconductor device 500M may be formed by the semiconductor die 210, the molded compound 240, the gel 222, and the thermal dissipation structure 230A. In addition, the gel 222 may further completely cover the top surface 240T of the molded compound 240, as a result, the closed space may be formed by the semiconductor die 210, the gel 222 and the thermal dissipation structure 230A. According to some embodiments, the lid 220F may be used to provide mechanical support for forming the closed space. Therefore, the liquid metal 224 can be stably sealed in the closed space to avoid spillage of the liquid metal.

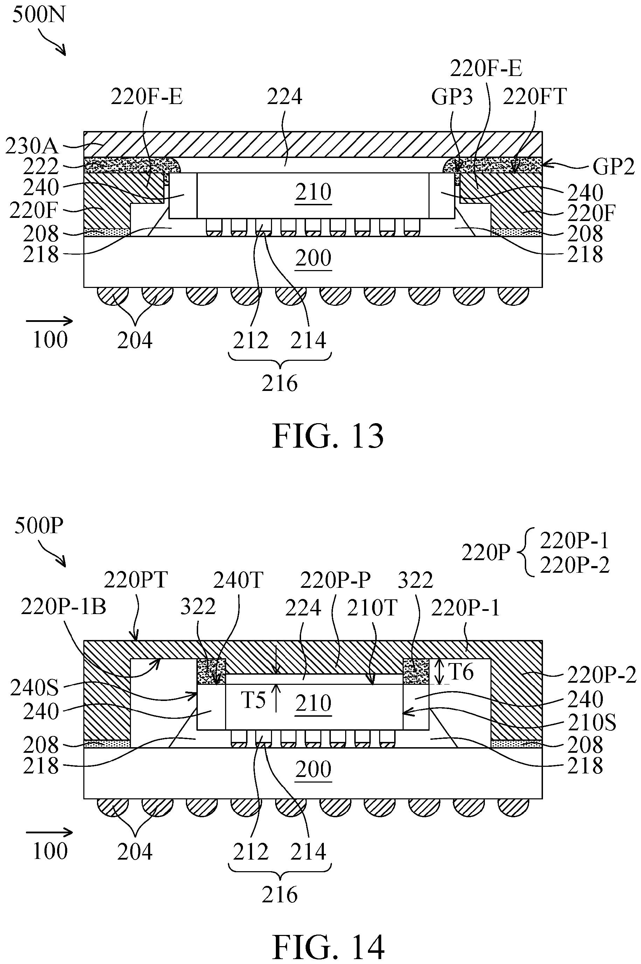

FIG. 13 is a cross-sectional view of a semiconductor device 500N in accordance with some embodiments of the disclosure. Elements of the embodiments hereinafter, that are the same or similar as those previously described with reference to FIGS. 1 to 12 are not repeated for brevity. The difference between the semiconductor device 500M and the semiconductor device 500N at least includes that the semiconductor device 500N uses the gel 222 sealing the gap GP3 between the molding compound 240 and the extending portion 220F-E and the gap GP2 between the thermal dissipation structure 230A and the top surface 220FT of the extending portion 220F-E (it also serves as the top surface of the lid 220F). Compared with the semiconductor device 500M, the molding compound 240 and the lid 220F of the semiconductor device 500N may be attached to the thermal dissipation structure 230A only by the gel 222 (without using the adhesive 226 shown in FIG. 12). In some embodiments, the closed space of the semiconductor device 500N may be formed by the semiconductor die 210, the molded compound 240, the gel 222, and the thermal dissipation structure 230A, as shown in FIG. 13. In addition, the gel 222 may further completely cover the top surface 240T of the molded compound 240, as a result, the closed space may be formed by the semiconductor die 210, the gel 222 and the thermal dissipation structure 230A. According to some embodiments, the lid 220F may be used to provide mechanical support for forming the closed space. Therefore, the liquid metal 224 can be stably sealed in the closed space to avoid spillage of the liquid metal.

In some embodiments in which the semiconductor die is surrounded by the molding compound, the lid of the semiconductor device may be an integrated structure fully covering the top surface and side surfaces of the semiconductor die. The liquid metal is disposed between the semiconductor die and the lid and surrounded by the gel (or the adhesive).

FIG. 14 is a cross-sectional view of a semiconductor device 500P in accordance with some embodiments of the disclosure. Elements of the embodiments hereinafter, that are the same or similar as those previously described with reference to FIGS. 1 to 13 are not repeated for brevity. As show in FIG. 14, the semiconductor device 500P includes the substrate 200, the conductive structures 204 and 216, the adhesive 208, the semiconductor die 210, the molding compound 240, the liquid metal 224, a lid 220P and a gel 322.

The difference between the semiconductor device 500J and the semiconductor device 500P at least includes that the semiconductor device 500P is fabricated without using the thermal dissipation structure. As show in FIG. 14, the lid 220P of the semiconductor device 500P is disposed on the substrate 200 and covers the semiconductor die 210 and the molding compound 240. The lid 220P may be an integrated structure without any through hole located at the lid 220P. The lid 220P includes an upper portion 220P-1 and a lower portion 220P-2 connected to the upper portion 220P-1. The upper portion 220P-1 may laterally extend over the semiconductor die 210 to cover the entire top surface 210T of the semiconductor die 210 and the entire top surface 240T of the molding compound 240. The lower portion 220P-2 may vertically extend to cover the entire side surface 2105 of the semiconductor die 210 and an entire side surface 2405 of the molding compound 240. In some embodiments, the lid 220P has an inverted-U shape in the cross-sectional view as shown in FIG. 14. The substrate 200 and the lid 220P connected to each other by the adhesive 208 may collectively form a closed space to accommodate the semiconductor die 210 and the molding compound 240.

As shown in FIG. 14, the gel 322 is disposed on the top surface 240T of the molding compound 240. The gel 322 is arranged between the molding compound 240 and the lid 220P without extending to cover the top surface 210T of the semiconductor die 210. In addition, the gel 322 is in contact with the top surface 240T of the molding compound 240 and a bottom surface 220P-1B of the upper portion 220P-1 of the lid 220P. In some embodiments, the gel 222, 322 and the adhesives 208, 226 may comprise the same or similar materials. In some embodiments, the lid 220P has a top surface 220PT opposite to the bottom surface 220P-1B, the top surface 220PT of the lid 220P may be a flat surface and the lid 220P has no opening on the top surface 220PT.

In some embodiments, the lid 220P has at least one protrusion portion 220P-P protruding from the bottom surface 220P-1B of the upper portion 220P-1 of the lid 220P. In other words, the bottom surface 220P-1B of the upper portion 220P-1 of the lid 220P is not a flat surface. The at least one protrusion portion 220P-P may extend towards the top surface 210T of the semiconductor die 210 and surrounded by the gel 322. For example, the gel 322 may be in contact with side surfaces of the protrusion portion 220P-P.

As shown in FIG. 14, the liquid metal 224 is arranged between and in contact with the entire top surface 210T of the semiconductor die 210 and the lid 220P. In addition, the liquid metal 224 may be surrounded by the gel 322. Moreover, the semiconductor die 210 and the lid 220P sealed each other by the gel 322 may collectively form a closed space to accommodate the liquid metal 224 filling within, thereby providing a heat dissipating path with low-thermal resistance. In some embodiments, as shown in FIG. 14, gel 322 may completely cover the top surface 240T of the molded compound 240, as a result, the semiconductor die 210, the lid 220P and the gel 322 form the closed space to accommodate the liquid metal 224, thereby providing a heat dissipating path with low-thermal resistance. In more detail, the closed space of the semiconductor device 500P may be formed by the semiconductor die 210, the gel 322 and the at least one protrusion portion 220P-P of the integrated lid 220P. In some embodiments, gel 322 may partly cover the top surface 240T of the molded compound 240, then the closed space of the semiconductor device 500P may be formed by the semiconductor die 210, the molded compound 240, the gel 322 and the lid 220P. Therefore, the liquid metal 224 can be stably sealed in the closed space to avoid spillage of the liquid metal.

In some embodiments, the protrusion portion 220P-P of the integrated lid 220P may reduce a thickness T5 of the liquid metal 224 (e.g., the thickness T5 of the liquid metal 224 of the semiconductor device 500P is thinner than a thickness T1 of the liquid metal 224 of the semiconductor device 500J shown in FIG. 10) in order to improve heat dissipation efficiency and speed up heat dissipation. In addition, the thickness T5 of the liquid metal 224 may be thinner than a thickness T6 of the gel 322. Therefore, the heat dissipation capability of the semiconductor device 500P can be further improved.

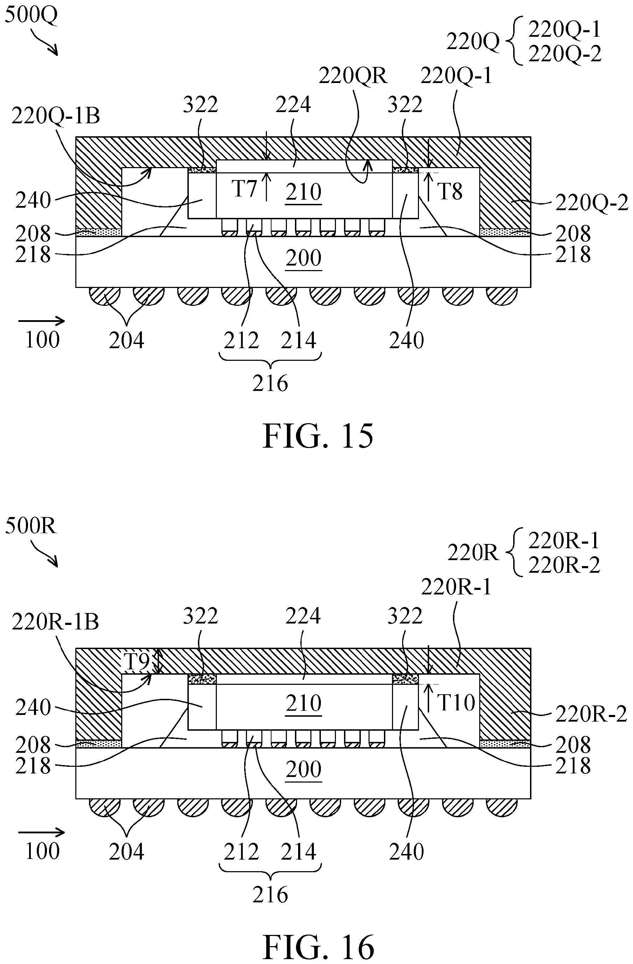

FIG. 15 is a cross-sectional view of a semiconductor device 500Q in accordance with some embodiments of the disclosure. Elements of the embodiments hereinafter, that are the same or similar as those previously described with reference to FIGS. 1 to 14 are not repeated for brevity. As show in FIG. 15, the difference between the semiconductor device 500P and the semiconductor device 500Q at least includes that the semiconductor device 500Q includes a lid 220Q. The lid 220Q includes an upper portion 220Q-1 and a lower portion 220Q-2 connected to the upper portion 220Q-1. The lid 220Q may have at least one recess 220QR on a bottom surface 220Q-1B of an upper portion 220Q-1 of the lid 220Q. In other words, the bottom surface 220Q-1B of the upper portion 220Q-1 of the lid 220Q is not a flat surface. In some embodiments, the at least one recess 220QR of the lid 220Q provides an additional space to accommodate the liquid metal 224. A thickness T7 of the liquid metal 224 may be greater than a thickness T8 of the gel 322. The total height of the semiconductor device 500Q can be further reduced. In some embodiments, as shown in FIG. 15, the gel 322 may completely cover the top surface 240T of the molded compound 240, as a result, the closed space of the semiconductor device 500Q may be formed by the semiconductor die 210, the gel 322 and the lid 220Q. In more detail, the closed space of the semiconductor device 500Q may be formed by the semiconductor die 210, the gel 322 and the at least one recess 220QR of the lid 220Q. In some embodiments, the gel 322 may partly cover the top surface 240T of the molded compound 240, then the closed space of the semiconductor device 500Q may be formed by the semiconductor die 210, the molded compound 240, the gel 322 and the lid 220Q. Therefore, the liquid metal 224 can be stably sealed in the closed space to avoid spillage of the liquid metal.

FIG. 16 is a cross-sectional view of a semiconductor device 500R in accordance with some embodiments of the disclosure. Elements of the embodiments hereinafter, that are the same or similar as those previously described with reference to FIGS. 1 to 15 are not repeated for brevity. As show in FIG. 16, the difference between the semiconductor device 500P and the semiconductor device 500R at least includes a lid 220R with an upper portion 220R-1 and a lower portion 220R-2 connected to the upper portion 220R-1. Compared with the semiconductor devices 500P and 500Q, the upper portion 220R-1 of the semiconductor device 500R has a uniform thickness T9 (the upper portion 220R-1 is formed without protrusion portions or recesses). In addition, the liquid metal 224 and the gel 322 may have the same thickness T10. In some embodiments, as shown in FIG. 16, the gel 322 may completely cover the top surface 240T of the molded compound 240, as a result, the closed space of the semiconductor device 500R may be formed by the semiconductor die 210, the gel 322 and the lid 220R. In more detail, the closed space of the semiconductor device 500R may be formed by the semiconductor die 210, the gel 322 and the bottom surface 220R-1B of an upper portion 220R-1 of the lid 220R. In some embodiments, the gel 322 may partly cover the top surface 240T of the molded compound 240, then the closed space of the semiconductor device 500R may be formed by the semiconductor die 210, the molded compound 240, the gel 322 and the lid 220R. Therefore, the liquid metal 224 can be stably sealed in the closed space to avoid spillage of the liquid metal.

Embodiments provide a semiconductor device. The semiconductor device may include a substrate, a semiconductor die, a lid, a liquid metal, a gel and a thermal dissipation structure. In some embodiments, the lid and the thermal dissipation structure connected to each other may collectively form a composite lid. The lid may include an extending portion extending towards the semiconductor die. The lid may have an opening to expose the semiconductor die. The gel is disposed between the semiconductor die and the lid. The thermal dissipation structure is disposed on the lid and covers the opening. The liquid metal disposed on the semiconductor die and in the opening. The thermal dissipation structure covers the liquid metal. In some embodiments, as the gap between the semiconductor die and the extending portion of the lid is sealed by the gel and the adhesive is disposed between the lid and the thermal dissipation structure, in a result, the semiconductor die, extending portion of the lid and the thermal dissipation structure may collectively form a closed space to accommodate the liquid metal filling within, thereby providing a heat dissipating path with low-thermal resistance. In addition, as the liquid metal is stably sealed in the closed space, when the semiconductor device is shipped, the area of the top surface of the semiconductor die covered by the liquid metal may keep the same. Being stably sealed in the closed space can also prevent the liquid metal from leaking to outside. Therefore, the circuit short problem is eliminated, and the heat dissipation capability of the semiconductor device can be further improved. In some embodiments, the thermal dissipation structure may have the protrusion portion protruding from the top surface of the thermal dissipation structure to increase the surface area of the thermal dissipation structure, thereby improving heat dissipation efficiency. In some embodiments, thermal dissipation structure may have protrusion portion protruding from the bottom surface of the thermal dissipation structure to reduce the thickness of the liquid metal in order to improve heat dissipation efficiency and speed up heat dissipation. In some embodiments, the thermal dissipation structure may have the recess providing the addition space for the gel filling within. Therefore, the seal quality of the semiconductor device may be improved. In some embodiments, the lid having the opening to expose the semiconductor die may have a reduced height in order to reduce the total height of the semiconductor device. In some embodiments, the semiconductor device includes the molding compound surrounding the semiconductor die. The molding compound may help to dissipate heat generated form the semiconductor die. In addition, the molding compound may provide an additional area for the dispensation of the gel. The thermal path area between the semiconductor die and the liquid metal may be increased. In some embodiments in which the semiconductor die is surrounded by the molding compound, the lid of the semiconductor device may have an integrated structure without openings (or the through holes). The lid may fully cover the top surface and side surfaces of the semiconductor die. The semiconductor die and the lid connected each other may collectively form a closed space to accommodate the liquid metal filling within. The liquid metal may be disposed between the entire top surface of the semiconductor die and the lid and surrounded by the gel (or the adhesive). The thickness of the liquid metal and the total height of the semiconductor device may be further reduced while the semiconductor device has a recess on the bottom surface of the lid.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined the following numbered clauses.
1. A semiconductor device, comprising:
   a substrate;
   a semiconductor die disposed on the substrate;
   a lid disposed on the substrate and covering the semiconductor die, wherein the lid has an opening to expose the semiconductor die; and
   a liquid metal disposed on the semiconductor die;
   a gel disposed between the semiconductor die and the lid; and
   a thermal dissipation structure disposed on the lid and covering the liquid metal, wherein the semiconductor die, the gel and the thermal dissipation structure form a closed space for accommodating the liquid metal.
2. The semiconductor device as claimed in clause 1, wherein the lid comprises an extending portion extending towards the semiconductor die, and the gel is in contact with the extending portion of the lid to seal a gap between the semiconductor die and the extending portion.
3. The semiconductor device as claimed in clause 2, wherein a bottom surface of the extending portion is higher than or flush with a top surface of the semiconductor die.
4. The semiconductor device as claimed in clause 2, wherein a top surface of the thermal dissipation structure is flush with a top surface of the lid.
5. The semiconductor device as claimed in clause 2, wherein the thermal dissipation structure has at least one protrusion portion protruding from a top surface of the thermal dissipation structure.
6. The semiconductor device as claimed in clause 2, wherein the thermal dissipation structure has at least one protrusion portion facing the opening, and the protrusion portion protrudes from a bottom surface of the thermal dissipation structure.
7. The semiconductor device as claimed in clause 2, wherein a bottom surface of the extending portion is lower than the top surface of the semiconductor die, and the top surface of the semiconductor die is lower than or flush with a top surface of the extending portion.
8. The semiconductor device as claimed in clause 2, wherein the gel is affixed to the thermal dissipation structure.
9. The semiconductor device as claimed in clause 8, wherein the thermal dissipation structure covers a top surface of the extending portion, and the gel fills a gap between the thermal dissipation structure and the top surface of the extending portion.
10. The semiconductor device as claimed in clause 8, wherein the gel fills a recess of the thermal dissipation structure, wherein the recess is recessed from a bottom surface of the thermal dissipation structure.
11. The semiconductor device as claimed in clause 1, wherein the gel is arranged on an edge of a top surface of the semiconductor die.
12. The semiconductor device as claimed in clause 1, wherein the lid is arranged on the substrate by an adhesive.
13. The semiconductor device as claimed in clause 1, wherein the thermal dissipation structure is arranged on the lid by an adhesive.
14. The semiconductor device as claimed in clause 2, further comprising:
   a molding compound surrounding the semiconductor die;
   wherein the gel is arranged on an edge of a top surface of the molding compound.
15. The semiconductor device as claimed in clause 14, wherein the liquid metal is in contact with an entire top surface of the semiconductor die.
16. The semiconductor device as claimed in clause 14, wherein a bottom surface of the extending portion is higher than or flush with a top surface of the semiconductor die; or the bottom surface of the extending portion is lower than the top surface of the semiconductor die.
17. The semiconductor device as claimed in clause 14, wherein a top surface of the extending portion is flush with a top surface of the semiconductor die.
18. A semiconductor device, comprising:
   a substrate;
   a semiconductor die disposed on the substrate;
   a molding compound surrounding the semiconductor die;
   a lid disposed on the substrate and covering the semiconductor die and the molding compound;
   a gel arranged between the molding compound and the lid; and
   a liquid metal arranged between an entire top surface of the semiconductor die and the lid, wherein the semiconductor die, the lid and the gel form a closed space for accommodating the liquid metal.
19. The semiconductor device as claimed in clause 18, wherein the lid has a recess on a bottom surface of the lid; or the lid has a protrusion portion protruding from the bottom surface of the lid.
20. The semiconductor device as claimed in clause 18, wherein the lid is an integrated structure

## Claims

1. A semiconductor device (500a, 500b, 500c, 500d, 500e, 500f, 500g, 500h, 500i, 500j, 500k, 500m, 500n), comprising:
a substrate (200);
a semiconductor die (210) disposed on the substrate (200);
a lid (220a, 220c, 220e, 220f) disposed on the substrate (200) and covering the semiconductor die (210), wherein the lid (220a, 220c, 220e, 220f) has an opening (221) to expose the semiconductor die (210); and
a liquid metal (224) disposed on the semiconductor die (210);
a gel (222, 322) disposed between the semiconductor die (210) and the lid (220a, 220c, 220e, 220f, 220p, 220q, 220r); and
a thermal dissipation structure (230a, 230b, 230c, 230d, 230h) disposed on the lid (220a, 220c, 220e, 220f) and covering the liquid metal (224), wherein the semiconductor die (210), the gel (222, 322) and the thermal dissipation structure (230a, 230b, 230c, 230d, 230h) form a closed space for accommodating the liquid metal (224).

2. The semiconductor device (500a, 500b, 500c, 500d, 500e, 500f, 500g, 500h, 500i, 500j, 500k, 500m, 500n) as claimed in claim 1, wherein the lid (220a, 220c, 220e, 220f) comprises an extending portion (220a-e, 220c-e, 220e-e, 220f-e) extending towards the semiconductor die (210), and the gel (222, 322) is in contact with the extending portion (220a-e, 220c-e, 220e-e, 220f-e) of the lid (220a, 220c, 220e, 220f) to seal a gap between the semiconductor die (210) and the extending portion (220a-e, 220c-e, 220e-e, 220f-e).

3. The semiconductor device (500a, 500b, 500c, 500d, 500e, 500f, 500g, 500h, 500i, 500j, 500k, 500m, 500n) as claimed in claim 2, wherein a bottom surface (220a-eb) of the extending portion (220a-e, 220c-e, 220e-e, 220f-e) is higher than or flush with a top surface (210t) of the semiconductor die (210); or
wherein a top surface (230ct) of the thermal dissipation structure (230c) is flush with a top surface (220ct) of the lid (220c).

4. The semiconductor device (500a, 500b, 500c, 500d, 500e, 500f, 500g, 500h, 500i, 500j, 500k, 500m, 500n) as claimed in claim 2, wherein the thermal dissipation structure (230b) has at least one protrusion portion (230b-p) protruding from a top surface (230bt) of the thermal dissipation structure (230b); or wherein the thermal dissipation structure (230d) has at least one protrusion portion (230d-p) facing the opening (221), and the at least one protrusion portion (230d-p) facing the opening protrudes from a bottom surface (230db) of the thermal dissipation structure (230d).

5. The semiconductor device (500a, 500b, 500c, 500d, 500e, 500f, 500g, 500h, 500i, 500j, 500k, 500m, 500n) as claimed in claim 2, wherein a bottom surface (220e-eb, 220f-eb) of the extending portion (220a-e, 220c-e, 220e-e, 220f-e) is lower than the top surface (210t) of the semiconductor die (210), and the top surface (210t) of the semiconductor die (210) is lower than or flush with a top surface (220at, 220ct, 220et, 220ft) of the extending portion (220a-e, 220c-e, 220e-e, 220f-e).

6. The semiconductor device (500a, 500b, 500c, 500d, 500e, 500f, 500g, 500h, 500i, 500j, 500k, 500m, 500n) as claimed in claim 2, wherein the gel (222) is affixed to the thermal dissipation structure (230a, 230b, 230c, 230d, 230h).

7. The semiconductor device (500a, 500b, 500c, 500d, 500e, 500f, 500g, 500h, 500i, 500j, 500k, 500m, 500n) as claimed in claim 6, wherein the thermal dissipation structure (230a, 230b, 230c, 230d, 230h) covers a top surface (220at, 220ct, 220et, 220ft) of the extending portion (220a-e, 220c-e, 220e-e, 220f-e), and the gel (222) fills a gap between the thermal dissipation structure (230a, 230b, 230c, 230d, 230h) and the top surface (220at, 220ct, 220et, 220ft) of the extending portion (220a-e, 220c-e, 220e-e, 220f-e).

8. The semiconductor device (500a, 500b, 500c, 500d, 500e, 500f, 500g, 500h, 500i, 500j, 500k, 500m, 500n) as claimed in claim 6, wherein the gel (222) fills a recess (230hr) of the thermal dissipation structure (230a, 230b, 230c, 230d, 230h), wherein the recess (230hr) is recessed from a bottom surface (200b, 210b, 230db, 230hb, 240b) of the thermal dissipation structure (230a, 230b, 230c, 230d, 230h).

9. The semiconductor device (500a, 500b, 500c, 500d, 500e, 500f, 500g, 500h, 500i, 500j, 500k, 500m, 500n) as claimed in claim 1, wherein the gel (222) is arranged on an edge of a top surface (210t) of the semiconductor die (210).

10. The semiconductor device (500a, 500b, 500c, 500d, 500e, 500f, 500g, 500h, 500i, 500j, 500k, 500m, 500n) as claimed in claim 1, wherein the lid (220a, 220c, 220e, 220f) is arranged on the substrate (200) by an adhesive (208); or wherein the thermal dissipation structure (230a, 230b, 230c, 230d, 230h) is arranged on the lid (220a, 220c, 220e, 220f) by an adhesive (226, 226c).

11. The semiconductor device (500a, 500b, 500c, 500d, 500e, 500f, 500g, 500h, 500i, 500j, 500k, 500m, 500n) as claimed in claim 2, further comprising:
a molding compound (240) surrounding the semiconductor die (210);
wherein the gel (222) is arranged on an edge of a top surface (240t) of the molding compound (240).

12. The semiconductor device (500a, 500b, 500c, 500d, 500e, 500f, 500g, 500h, 500i, 500j, 500k, 500m, 500n) as claimed in claim 11, wherein the liquid metal (224) is in contact with an entire top surface (210t) of the semiconductor die (210).

13. The semiconductor device (500a, 500b, 500c, 500d, 500e, 500f, 500g, 500h, 500i, 500j, 500k, 500m, 500n) as claimed in claim 11, wherein a bottom surface (220a-eb,220e-eb, 220f-eb) of the extending portion (220a-e, 220c-e, 220e-e, 220f-e) is higher than or flush with a top surface (210t) of the semiconductor die (210); or the bottom surface (220a-eb,220e-eb, 220f-eb) of the extending portion (220a-e, 220c-e, 220e-e, 220f-e) is lower than the top surface (210t) of the semiconductor die (210); or wherein a top surface (220at, 220ct, 220et, 220ft, 220pt) of the extending portion (220a-e, 220c-e, 220e-e, 220f-e) is flush with a top surface (210t) of the semiconductor die (210).

14. A semiconductor device (500a, 500b, 500c, 500d, 500e, 500f, 500g, 500h, 500i, 500j, 500k, 500m, 500n, 500p, 500q, 500r), comprising:
a substrate (200);
a semiconductor die (210) disposed on the substrate (200);
a molding compound (240) surrounding the semiconductor die (210);
a lid (220a, 220c, 220e, 220f, 220p, 220q, 220r) disposed on the substrate (200) and covering the semiconductor die (210) and the molding compound (240);
a gel (222, 322) arranged between the molding compound (240) and the lid (220a, 220c, 220e, 220f, 220p, 220q, 220r); and
a liquid metal (224) arranged between an entire top surface (200t, 210t, 220at, 220ct, 220et, 220ft, 220pt, 230bt, 230ct, 230dt, 240t) of the semiconductor die (210) and the lid (220a, 220c, 220e, 220f, 220p, 220q, 220r), wherein the semiconductor die (210), the lid (220a, 220c, 220e, 220f, 220p, 220q, 220r) and the gel (222, 322) form a closed space for accommodating the liquid metal (224).

15. The semiconductor device (500p, 500q, 500r) as claimed in claim 14, wherein the lid (220q) has a recess (220qr) on a bottom surface (220q-1b) of the lid ( 220q ); or the lid (220p) has a protrusion portion (220p-p) protruding from the bottom surface (220p-1b) of the lid (220p); or wherein the lid (220p, 220q, 220r) is an integrated structure.
